# EUROPÄISCHE PATENTANMELDUNG

(11) **EP 2 144 299 A2**
(43) Veröffentlichungstag der Anmeldung: **13.01.2010**
(21) Anmeldenummer: 09007328.9
(22) Anmeldetag: 03.06.2009
(51) Int. Cl.: H01L 31/042

(54) **Befließungseinrichtung für eine Solaranlage**

(30) Priorität: 26.06.2008 DE 102008030372; 18.10.2008 DE 102008052301
(71) Anmelder: Pleva ING. Solar + Biotech, 72160 Horb (DE)
(72) Erfinder: Pleva, Harry, 72160 Horb (DE); Pleva, Ralf, Dr., 72160 Horb (DE)
(74) Vertreter: Wasmuth, Rolf

(57) **Zusammenfassung**

Die Erfindung betrifft eine Befließungseinrichtung (3) für eine Solaranlage sowie eine Solaranlage mit einer solchen Befließungseinrichtung (3). Die Solaranlage umfasst eine Anordnung von schräg zur Horizontalen ausgerichteten photovoltaischen Solarmodulen (1), die mit einer Bestrahlungsseite (2) der Sonne zugewandt sind. Die Befließungseinrichtung (3) ist zur Erzeugung eines sich auf der Bestrahlungsseite (2) der Solarmodule (1) ausbildenden, zur Umgebung hin offenen fließenden Wasserfilmes (4) vorgesehen und weist einen in einer horizontalen Querrichtung (5) sich erstreckenden Wasseraustritt (6) auf. Die Befließungseinrichtung (3) weist des Weiteren mindestens zwei Beruhigungskammern (7, 8) auf, wobei die in Durchströmungsrichtung letzte Beruhigungskammer (8) mit dem Wasseraustritt (6) versehen ist. Zwischen den Beruhigungskammern (7, 8) verläuft eine Trennwand (9) mit einer in der horizontalen Querrichtung (5) sich erstreckenden Umströmungskante (10).

## Beschreibung

Die Erfindung betrifft eine Befließungseinrichtung für eine Solaranlage mit den Merkmalen nach dem Oberbegriff des Anspruchs 1 sowie eine Solaranlage mit einer entsprechenden Befließungseinrichtung.

Solaranlagen mit fotovoltaischen Solarmodulen erzeugen unter Sonneneinstrahlung elektrische Energie, die direkt einem Verbraucher zugeführt oder ins öffentliche Stromnetz eingespeist werden kann. Sonnenenergie ist zwar kostenfrei verfügbar, der niedrige Wirkungsgrad heute bekannter fotovoltaischer Solarmodule erfordert jedoch hohe Investitions- und Unterhaltskosten, die die Wirtschaftlichkeit von fotovoltaischen Solaranlagen einschränken. Insbesondere in höheren Breitengraden, wo geografisch und meteorologisch bedingt nur eine begrenzte Sonnescheindauer zur Verfügung steht, sind vergleichsweise große, kostenintensive Solaranlagen zur Gewinnung einer gewünschten mittleren elektrischen Energiemenge erforderlich.

Zur Steigerung des Wirkungsgrades und zur Senkung der Kosten sind zahlreiche Maßnahmen bekannt. Solarmodule beschränkter Größe können beispielsweise in Horizontal- und Vertikalrichtung geschwenkt und dem Sonnenstand nachgeführt werden. Hierdurch kann ein zumindest näherungsweise rechtwinkliger Sonneneinfall der Sonnenbestrahlung auf die Strahlungsseite der Solarmodule sichergestellt werden. Die mittlere Sonneneinstrahlungsdauer ist damit jedoch nicht verlängerbar.

Als weiterer einschränkender Faktor für die elektrische Stromausbeute ist der Wirkungsgradverlust bei steigender Modultemperatur bekannt. In zahlreichen, aus dem Stand der Technik bekannten Anordnungen wird deshalb eine aktive Kühlung der Solarmodule durch einen Wasserkreislauf vorgeschlagen. Aus der WO 2008/025461 und der DE 295 07 178 U1 sind hierzu Befließungseinrichtungen für eine Solaranlage bekannt, wobei die jeweilige Befließungseinrichtung zur Erzeugung eines sich auf der Bestrahlungsseite der Solarmodule ausbildenden, zur Umgebung hin offenen fließenden Wasserfilmes vorgesehen ist. Dieser über die Solarmodule abfließende Wasserfilm kühlt die Solarmodule und steigert damit ihren Wirkungsgrad. Außerdem trägt er Schmutzpartikel fort, wodurch die Oberfläche zur Steigerung des Wirkungsgrades immer sauber bleibt. Auch werden die Solarmodule vor abrasiven Umwelteinflüssen geschützt.

In der Praxis hat sich jedoch herausgestellt, dass die Erzeugung eines gleichmäßigen und in seiner Dicke geeigneten Wasserfilmes schwierig ist. Bei in ihrer Neigung einstellbaren Solarmodulen muss sich der Wasserfilm an die jeweils gewählte unterschiedliche Neigung anpassen. Insgesamt darf der Wasserfilm weder zu dick noch zu dünn sein, und muss außerdem über die gesamte Fläche der Solarmodule verteilt eine gleichmäßige Dicke aufweisen. Die beiden vorgenannten Druckschriften geben keine geeigneten Mittel an, wie die Erzeugung eines derart gleichmäßigen Wasserfilmes erreicht werden kann.

Der Erfindung liegt die Aufgabe zugrunde, eine gattungsgemäße Befließungseinrichtung derart weiterzubilden, dass sich ein flächig gleichmäßig verteilter Wasserfilm auf dem Solarmodul ausbildet.

Diese Aufgabe wird durch eine Befließungseinrichtung mit den Merkmalen des Anspruchs 1 gelöst.

Der Erfindung liegt des Weiteren die Aufgabe zugrunde, eine Solaranlage mit einer Befließungseinrichtung anzugeben, die unter verschiedenen Witterungsbedingungen zuverlässig einen hohen Wirkungsgrad aufweist.

Diese Aufgabe wird durch eine Solaranlage mit den Merkmalen des Anspruchs 8 gelöst.

Es wird eine Befließungseinrichtung für eine Solaranlage sowie eine Solaranlage mit einer entsprechenden Befließungseinrichtung vorgeschlagen, wobei die Befließungseinrichtung mindestens zwei Beruhigungskammern aufweist, wobei die in Durchströmungsrichtung letzte Beruhigungskammer mit einem in einer horizontalen Querrichtung sich erstreckenden Wasseraustritt versehen ist, und wobei zwischen den Beruhigungskammern eine Trennwand mit einer in der horizontalen Querrichtung sich erstreckenden Umströmungskante verläuft.

Über einen Wasserzulauf wird Wasser zunächst in die erste Beruhigungskammer eingeleitet, die sich in der Querrichtung erstreckt. Diese erste Beruhigungskammer weist keine direkte strömungsleitende Verbindung zum Wasseraustritt der Befließungseinrichtung auf. Das eintretende Wasser ist deshalb gezwungen, sich in der Querrichtung der ersten Beruhigungskammer auszubreiten, wobei eine Strömungsberuhigung eintritt. Das derart zumindest näherungsweise gleichmäßig verteilte und beruhigte Wasser fließt anschließend um die Umströmungskante der Trennwand, wodurch eine weitere Strömungsberuhigung eintritt. In diesem Zustand ist das Wasser bereits in der Querrichtung gleichmäßig verteilt und tritt in dieser gleichmäßig verteilten Form in die zweite Beruhigungskammer ein, wo sich ein in der Querrichtung gleichmäßig verteilter, strömungsberuhigter Wasservorrat für den Wasseraustritt ansammelt. Der Wasseraustritt wird schließlich aus diesem beruhigten Wasservorrat gespeist. In der Folge tritt aus dem Wasseraustritt entlang seiner gesamten Quererstreckung ein gleichmäßig verteilter, filmartiger Wasserstrom aus, der sich als Wasserfilm mit in der Querrichtung konstanter Dicke auf die Außenseite der Solarmodule legt. Die Ausbildung von Bereichen mit erhöhter oder mit unterdurchschnittlicher Strömungsgeschwindigkeit ist ebenso wie die Ausbildung von Bereichen mit abweichender Filmdicke zuverlässig vermieden. Die Dicke des Wasserfilmes lässt sich aufgrund seiner Gleichmäßigkeit exakt an die herrschenden Witterungsverhältnisse und auch an die geometrischen Verhältnisse der Solarmodulneigung anpassen. Die Kühlwirkung für die Solarmodule und der sich in Abhängigkeit davon ergebende elektrische Wirkungsgrad lassen sich präzise und zuverlässig einstellen. Auch für die Nutzung als Warmwasser-Energiequelle lässt sich die Temperatur des Wasserfilms durch Einstellung der Filmdicke und Fließgeschwindigkeit sauber einstellen.

Es kann zweckmäßig sein, dass die Trennwand zwischen den beiden Beruhigungskammern nicht bis nach unten zum Boden des Kammergehäuses verläuft, sondern dass zwischen der Unterkante der Trennwand und dem Boden ein schmaler Spalt verbleibt. Die Umströmungskante der Trennwand ist dann hier als in Querrichtung verlaufende Unterkante ausgebildet, die zusammen mit dem Boden der Beruhigungskammern einen quer verlaufenden Schlitz bildet, durch den das Wasser von der ersten Beruhigungskammer in die zweite Beruhigungskammer hindurchtritt. In bevorzugter Weiterbildung ist die Umströmungskante eine in Gewichtskraftrichtung obere Überlaufkante. Sobald die eingangsseitige erste Beruhigungskammer einen hinreichenden Füllstand erreicht hat, fließt das Wasser hieraus über die exakt horizontal ausgerichtete Überlaufkante in die zweite Beruhigungskammer ab. Die Ausbildung eines düsenartigen Schlitzes ist nicht erforderlich. Vielmehr bildet sich ein in der Querrichtung gleichmäßig verteilter Überlauf mit geringer Strömungsgeschwindigkeit und hoher Gleichmäßigkeit aus, wodurch die Beruhigungswirkung auf den Wasserstrom weiter verbessert ist.

Es kann zweckmäßig sein, dass sich die beiden Beruhigungskammern nur über einen Teilbereich der Breite des Wasseraustrittes erstrecken. Hierzu weisen die Beruhigungskammern eine Breite von mindestens 60%, bevorzugt von mindestens 80% und insbesondere von mindestens 90% der Breite des Wasseraustrittes auf. Vorteilhaft erstrecken sich die beiden Beruhigungskammern über die gesamte Breite des Wasseraustrittes, so dass dieser auch in seinen Randbereichen einen vergleichmäßigten Wasserfilm zuverlässig erzeugt. Der Wasseraustritt selbst entspricht dabei in seiner Breite zumindest der Breite eines einzelnen Solarmoduls, so dass dieses Solarmodul ebenfalls über seine gesamte Breite mit einem gleichmäßigen Wasserfilm beaufschlagt wird. Die Ausbildung von einzelnen Zonen auf dem Solarmodul mit unzureichendem oder übermäßig dickem Wasserfilm ist vermieden.

In einer vorteilhaften Ausführungsform ist zumindest in der eingangsseitigen Beruhigungskammer ein Beruhigungsgitter angeordnet. Dieses wirkt auf das strömungstechnisch ungeordnet eintretende Wasser als Dämpfungselement und trägt mit hoher Wirksamkeit zur Beruhigung des Wasserstromes und zur Vergleichmäßigung über die Breite der Beruhigungskammer bei.

Der Wasseraustritt kann als Flachdüse, als Lochreihe oder dergleichen ausgebildet sein und ist vorteilhaft durch eine Schwelle mit einer in der horizontalen Querrichtung sich erstreckenden Schwellenkante gebildet. Sobald sich in der zweiten Beruhigungskammer eine hinreichender Füllstand gebildet hat tritt das Wasser vergleichbar zur vorstehend beschriebenen Überlaufkante über die Schwellenkante nach draußen auf die Solarmodule aus. Bei einer exakt horizontalen Ausrichtung der Schwellenkante ist die Ausbildung von Unregelmäßigkeiten im Wasserfilm zuverlässig vermieden.

Bevorzugt ist eine Steuerungseinrichtung zur Einstellung des freien Strömungsquerschnittes des Wasseraustrittes vorgesehen. Insbesondere ist die Steuerungseinrichtung durch eine die Schwellenkante überdeckende, in einer Hochrichtung verstellbare Zahnleiste gebildet. Je nach Höheneinstellung decken die Zähne einen Teil der Schwellenkante ab, während Wasser über die Schwellenkante durch die Lücken zwischen den Zähnen austreten kann. Diese Lücken lassen sich durch eine Hubbewegung der Zahnleiste in ihrer Größe einstellen, womit der Wasserfluss präzise an den aktuellen Bedarf angepasst werden kann. Die Zähne selbst tragen zu einer weiteren Beruhigung des Wasserstromes bei. Bei einer hinreichend feinen Zahnausbildung stellen die Zähne selbst keine technisch relevante Störung des Wasserstromes dar. Vielmehr vereinigen sich die vielen kleinen, durch die Zahnlücken hindurchtretenden Teilströme schon nach kurzer Laufstrecke stromab der Zahnleiste zu einem gleichmäßigen, in seiner Dicke konstanten, jedoch in seiner Dicke und Strömungsgeschwindigkeit einstellbaren Wasserfilm.

In der Querrichtung sich einstellende seitliche Neigungsfehler der Solarmodule und der Befließungseinrichtung sowie Unsymmetrien in der Befüllungsströmung der Beruhigungskammern können dazu führen, dass sich in der Querrichtung unterschiedliche Dicken des Wasserfilms einstellen. Schlimmstenfalls bildet sich an einigen Stellen der Wasserfilm überhaupt nicht aus, während er an anderen Stellen übermäßig dick ist.

Zum Ausgleich solcher Neigungsfehler und zur Erzielung eines Wasserfilms mit in der Querrichtung gleicher Dicke kann eine Höhen- bzw. Neigungsjustierung für die Solarmodule und/oder die Befließungseinrichtung zweckmäßig sein. Bevorzugt ist ein insbesondere mittig und quer zur horizontalen Querrichtung in die erste Beruhigungskammer mündender Wasserzulauf vorgesehen, wobei im Bereich des Wasserzulaufes einstellbare Umlenkmittel zur Umlenkung des eintretenden Wasserstromes in die horizontale Querrichtung angeordnet sind. In der Grundeinstellung wird durch die insbesondere mittige Anströmung der Beruhigungskammer eine symmetrische Befüllung erzeugt, die in exakt horizontaler Ausrichtung zu einem Wasserfilm mit in der Querrichtung konstanter Dicke führt. Sofern jedoch seitliche Neigungsfehler vorhanden sind, kann über die einstellbaren Umlenkmittel ein von der Symmetrie abweichendes Befüllungsprofil der Beruhigungskammern eingestellt werden, welches dem seitlichen Neigungsfehler entgegenwirkt. Trotz Neigungsfehlern lässt sich hierdurch mit einfachen Mitteln eine gleichmäßige Dicke des Wasserfilmes einstellen, ohne dass ein geometrischer Ausgleich des Neigungsfehlers erforderlich ist.

Die Umlenkmittel können einstellbare Leitbleche oder dergleichen sein. In bevorzugter Weiterbildung umfasst der Wasserzulauf einen drehbaren Einlaufstutzen, dessen Drehachse quer zur Querrichtung liegt, wobei der Einlaufstutzen einen der ersten Beruhigungskammer zugewandten Wasserkanalabschnitt aufweist, und wobei der Wasserkanalabschnitt zur Bildung der Umlenkmittel in einem von 0° abweichenden Winkel zur Drehachse liegt. Durch einfache anpassende Drehung des Einlaufstutzens lässt sich der abgewinkelte Wasserkanalabschnitt ausgehend von einer mittigen Neutralposition nach links oder rechts drehen, wodurch der eintretende Wasserstrom die gewünschte seitliche Richtungskomponente erhält. Die Anordnung ist wirkungsvoll und konstruktiv einfach im Aufbau. Die Justage der Wasserfilmdicke kann ohne besondere Hilfsmittel vorgenommen werden. Der drehbare Einlaufstutzen kann in einfacher Weise in der gefundenen Drehwinkelposition fixiert werden.

Als weitere Maßnahme zur Ausbildung eines gleichmäßigen und im Übrigen möglichst dünnen Wasserfilmes ist das Wasser bevorzugt mit Tensiden versetzt. Selbst bei einer sehr dünnen Einstellung des Wasserfilmes neigt dieser durch das Fehlen einer Oberflächenspannung nicht zum Aufreißen, so dass das beflossene Solarmodul gleichmäßig vom Wasserfilm bedeckt bleibt.

In einer vorteilhaften Ausführungsform weist die Oberfläche der Solarmodule auf der Bestrahlungsseite in einer Neigungsrichtung verlaufende Längsführungen auf. Hierdurch wird die Empfindlichkeit des Wasserfilms gegen geometrische Ausrichtungsfehler, gegen Seitenwindeinflüsse oder dergleichen verringert. Selbst auf nicht exakt eben oder in der Falllinie ausgerichteten Solarmodulen oder bei störenden Witterungseinflüssen bleibt ein gleichmäßiger Wasserfilm erhalten, da die Ausbildung von Richtungskomponenten der Filmströmung quer zur Falllinie vermieden ist.

In einer weiteren bevorzugten Ausführungsform ist eine Regelungseinrichtung für eine Füllstandsregelung des Wassers in der Beruhigungskammer, insbesondere in der letzten Beruhigungskammer vorgesehen. Hierdurch wird ein gleichmäßiger Wasserfüllstand sichergestellt, der am Wasseraustritt einen konstanten hydrostatischen Druck bereitstellt. Die gewünschte und einmal vorgenommene Einstellung des Wasserfilmes in Dicke und Strömungsgeschwindigkeit bleibt dauerhaft aufrechterhalten.

In einer bevorzugten Ausbildung ist eine Übergangsleiste zur Montage im Übergangsbereich von zwei in der Neigungsrichtung aneinander angrenzenden Solarmodulen vorgesehen, die sich dabei in der Querrichtung erstreckt, und wobei die Übergangsleiste in der Querrichtung verteilte und in der Neigungsrichtung ausgerichtete Leiteinrichtungen aufweist. Die vorstehend beschriebene Anordnung beruht auf der Erkenntnis, dass die Solarmodule in handelsüblichen Größen unter Bildung von Fugen in der Neigungsrichtung untereinander angeordnet werden müssen, wobei diese Fugen ohne weitere Maßnahmen die Ausbildung des gleichmäßigen Wasserfilms stören. Mit der Übergangsleiste wird die Fuge überbrückt. Die Leiteinrichtungen verhindern eine Querströmung des Wasserfilmes in diesem Übergangsbereich und lassen lediglich eine Überströmung der Fuge in der Neigungsrichtung zu. Hierdurch ist sichergestellt, dass der aufwärts gleichmäßig ankommende Wasserfilm auch nach Übertreten der Fuge seine gleichmäßige Dicken- und Strömungsverteilung beibehält.

In vorteilhafter Weiterbildung ist die Übergangsleiste durch ein Profil gebildet, welches sich im montierten Zustand über die Oberfläche der Solarmodule auf deren Bestrahlungsseite erhebt und dabei die Fuge zwischen den Solarmodulen überspannt, wobei die Leiteinrichtungen durch eine wechselseitige Anordnung von Rippen und zwischenliegenden Kanälen gebildet sind. Die über die Oberfläche erhabene Bauform der Übergangsleiste erzeugt eine geringfügige Stauwirkung des ankommenden Wasserfilmes, wodurch erneut eine Strömungsberuhigung eintritt. Die wechselseitige Anordnung von Rippen und zwischenliegenden Kanälen leitet das aufgestaute und beruhigte Wasser exakt in der Neigungsrichtung unter Vermeidung von Querströmungen zum nachfolgenden Solarmodul weiter. Bei einer hinreichend engen Anordnung von Rippen und Kanälen schließen sich die durch die einzelnen Kanäle durchtretenden Teilströme unmittelbar nach dem Passieren der Übergangsleiste selbsttätig zu einem gleichmäßigen Wasserfilm zusammen, der dann erneut, wie auch auf der Eingangsseite, mit gleichmäßiger Dicken- und Strömungsverteilung auf dem ausgangsseitigen Solarmodul abfließt. Die Kanäle sind in Folge ihrer nach außen bzw. in radialer Richtung offenen Bauweise selbstreinigend, so dass eine Verschmutzung bzw. Verstopfung durch Laub etc. vermieden ist.

Zur Bildung der Übergangsleiste können verschiedene Bauformen geeignet sein. In einer einfachen, kostengünstigen und wirkungsvollen Bauweise ist die Übergangsleiste durch einen der Länge nach geteilten Wellstab gebildet. Dieser kann preisgünstig als Meterware beschafft bzw. durch drehen hergestellt und in Längsrichtung beispielsweise halbiert werden. Ein solcher Halbquerschnitt oder Teilquerschnitt eines Wellstabes kann einfach montiert werden und überbrückt wirkungsvoll unter Beibehaltung des gleichmäßigen Wasserfilms die zwischenliegende Fuge.

Ein Ausführungsbeispiel der Erfindung ist nachfolgend anhand der Zeichnung näher beschrieben. Es zeigen:
- Fig. 1: eine perspektivische Schemadarstellung eines Hauses mit Pultdach und aufgesetzter fotovoltaischer Solar-anlage mit einer Befließungseinrichtung;
- Fig. 2: in perspektivischer, teilweise geschnittener Darstellung eine vergrößerte Detailansicht der Befließungseinrichtung nach Fig. 1 im Zusammenspiel mit einem Solarmodul;
- Fig. 3: in einer Querschnittsdarstellung die Befließungseinrichtung nach den Fig. 1 und 2 in Einzelheiten zu ihrem inneren Aufbau und Ausbildung des Wasseraustrittes;
- Fig. 4: in einer geschnittenen Draufsicht die Befließungsanlage nach den Fig. 2 und 3 im Bereich ihres Wasserzulaufes mit Einzelheiten zu einem drehend einstellbaren Einlaufstutzen;
- Fig. 5: eine Querschnittsdarstellung des Einlaufstutzens nach Fig. 4 mit weiteren Einzelheiten zu seinen möglichen Drehwinkelstellungen;

- Fig. 6: in einer Draufsicht eine vergrößerte Detailansicht der Solaranlage nach Fig. 1 im Fugenbereich zweier in der Neigungsrichtung aneinander angrenzenden Solarmodule mit einer die zwischenliegenden Fuge überspannenden Übergangsleiste;
- Fig. 7: in einer Querschnittsdarstellung die Anordnung nach Fig. 6 mit Einzelheiten zur Überleitung des Wasserfilmes von einem Solarmodul zu dem in der Neigungsrichtung nachfolgenden Solarmodul.

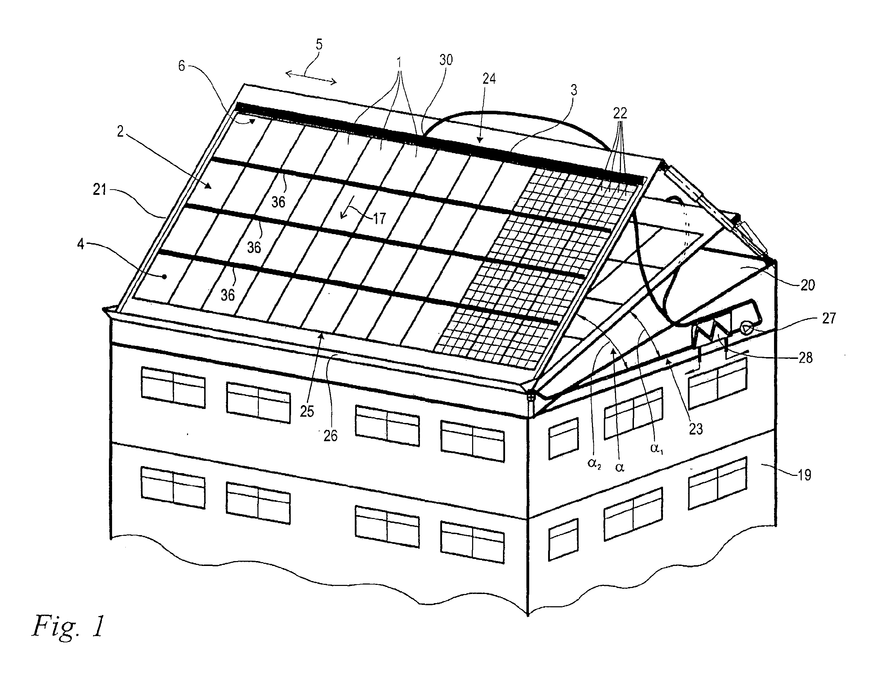

Fig. 1 zeigt eine perspektivische Schemadarstellung eines Gebäudes 19, dessen Dach 20 im gezeigten Ausführungsbeispiel als Pultdach ausgeführt ist. Es kann auch ein Satteldach oder dergleichen zweckmäßig sein. Das Gebäude 19 steht auf der nördlichen Erdhalbkugel. Die Dachfläche des Pultdaches ist zumindest näherungsweise nach Süden gegen die Mittagssonne ausgerichtet. Analog dazu ist auf der südlichen Erdhalbkugel eine Ausrichtung nach Norden vorzusehen. Auf dem Pultdach 20 ist in gleicher Ausrichtung zur Himmelsrichtung eine Trägerkonstruktion 21 angeordnet, die in ihrer Grundfläche zumindest näherungsweise der Dachfläche des Pultdaches 20 bzw. der Grundfläche des Gebäudes 19 entspricht.

Die Trägerkonstruktion 21 ist Teil einer Solaranlage und trägt eine Vielzahl von fotovoltaischen, in einer Ebene der Trägerkonstruktion 21 angeordneten Solarmodulen 1, die ihrerseits jeweils eine Vielzahl von miteinander verschalteten Solarzellen 22, umfassen. Die mittels der Trägerkonstruktion 21 auf dem Dach 20 des Gebäudes 19 montierte Anordnung von Solarmodulen 1 ist in einem Winkel α zur Horizontalen in einer Neigungsrichtung 17 geneigt. Der Winkel α ist in einem Winkelbereich zwischen einem unteren Winkel α₁ und einem oberen Winkel α₂ einstellbar. Hierdurch ist eine Bestrahlungsseite 2 der Solarmodule 1 der Sonne zumindest über einen Großteil ihres Tageslaufes zugewandt.

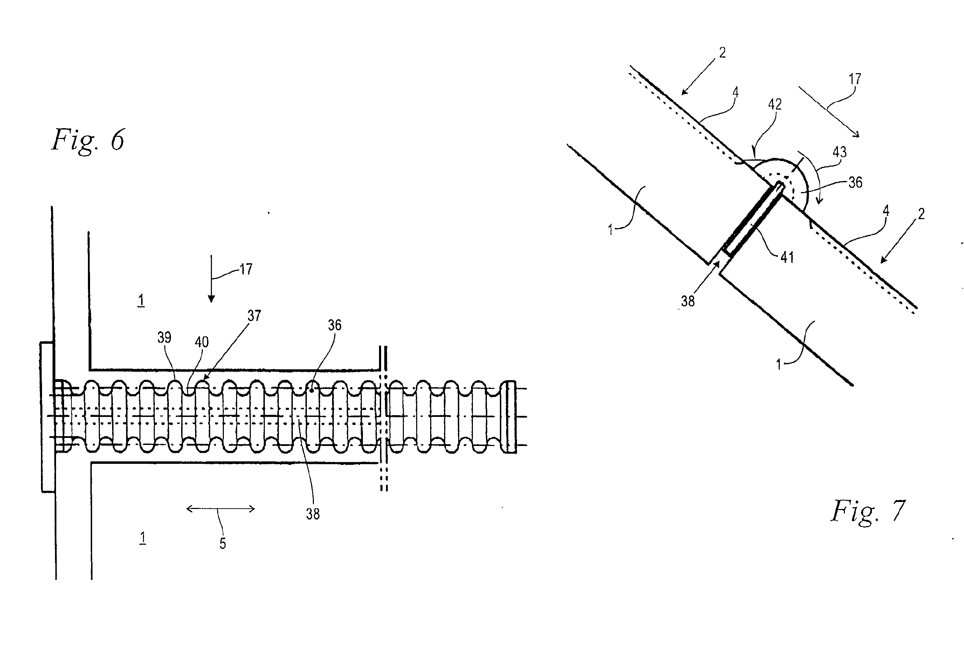

Die Solaranlage weist eine Befließungseinrichtung 3 auf, die zur Erzeugung eines sich auf der Bestrahlungsseite 2 der Solarmodule 1 ausbildenden, zur Umgebung hin offenen fließenden Wasserfilmes 4 vorgesehen ist. Zur Bildung des Wasserfilmes 4 ist im gezeigten Ausführungsbeispiel Wasser gewählt, welches zur Vergleichmäßigung seines Flusses mit Tensiden versetzt ist. Der Wasserfilm 4 ist Teil eines angedeuteten geschlossenen Wasserkreislaufes 23. Im Bereich einer Oberkante 24 der Anordnung vom Solarmodul 1 erstreckt sich die Befließungseinrichtung 3 in einer durch einen Doppelpfeil angegebenen horizontalen Querrichtung 5 und ist mit Wasseraustritten 6 versehen, die sich ebenfalls in der horizontalen Querrichtung 5 jeweils über die Breite eines Solarmoduls 1 erstrecken. Aus den Wasseraustritten 6 wird das mit den Tensiden versehene Wasser auf die Bestrahlungsseite 2 der Solarmodule 1 ausgetragen. Es bildet sich ein Wasserfilm 4 aus, der die Bestrahlungsseite 2 der Solarmodule 1 vollflächig abdeckt und unter Einwirkung der Schwerkraft in Richtung einer Unterkante 25 der Anordnung von Solarmodulen 1, also in der Neigungsrichtung 17 fließt. Es sind in der Querrichtung 5 sich erstreckende Übergangsleisten 36 vorgesehen, die den Übergangsbereich von jeweils zwei in der Neigungsrichtung 17 aneinander angrenzenden Solarmodulen 1 abdecken, so dass sich der Wasserfilm 4 über die gesamte Fläche der Solarmodule 1 ausgehend von der Befließungseinrichtung 3 bis hin zur Unterkante 25 ausbilden kann. Die Übergangsleisten 36 überspannen die gesamte Breite der in der Querrichtung 5 aneinander angrenzenden Solarmodule 1. Weitere Einzelheiten hierzu sind im Zusammenhang mit den Fig. 6 und 7 näher beschrieben.

An der Unterkante 25 wird das Wasser des Wasserfilmes 4 mittels einer Auffangrinne 26 aufgefangen und über den geschlossenen Wasserkreislauf 23 mittels einer Pumpe 27 über einen Wasserzulauf 30 zu der Befließungseinrichtung 3 zurückgeführt.

Der Flüssigkeitsfilm 4 ist zur Umgebung hin offen, also nicht abgedeckt. Von der Umgebung eingetragener Schmutz wie Staub oder dergleichen wird mit dem Wasserfilm 4 zur Auffangrinne 26 fortgetragen und kann beispielsweise durch einen nicht dargestellten Filter aus dem geschlossenen Wasserkreislauf 11 herausgefiltert werden. Gleichzeitig übt der Wasserfilm 4 eine Schutzfunktion für die Solarmodule 1 mit ihren fotovoltaischen Solarzellen 22 gegen abrasive Umwelteinflüsse aus. Im geschlossenen Wasserkreislauf 23 ist ein schematisch angedeuteter Wärmetauscher 28 vorgesehen, der eine Kühlung des Wassers bzw. des Wasserfilmes 4 erzeugt. Darüber hinaus erzeugt die zur Umgebung hin offene Ausbildung des Wasserfilms 4 eine Verdunstungsrate, die den Wasserfilm 4 zusätzlich abkühlt. Der gekühlte Wasserfilm 4 kühlt die Solarzellen 22 und steigert damit deren elektrischen Wirkungsgrad. Mittels des Wärmetauschers 28 kann ein nicht dargestellter Wärmespeicher beispielsweise in Form eines Wasserbehälters, eines Schwimmbeckens oder dergleichen erwärmt werden.

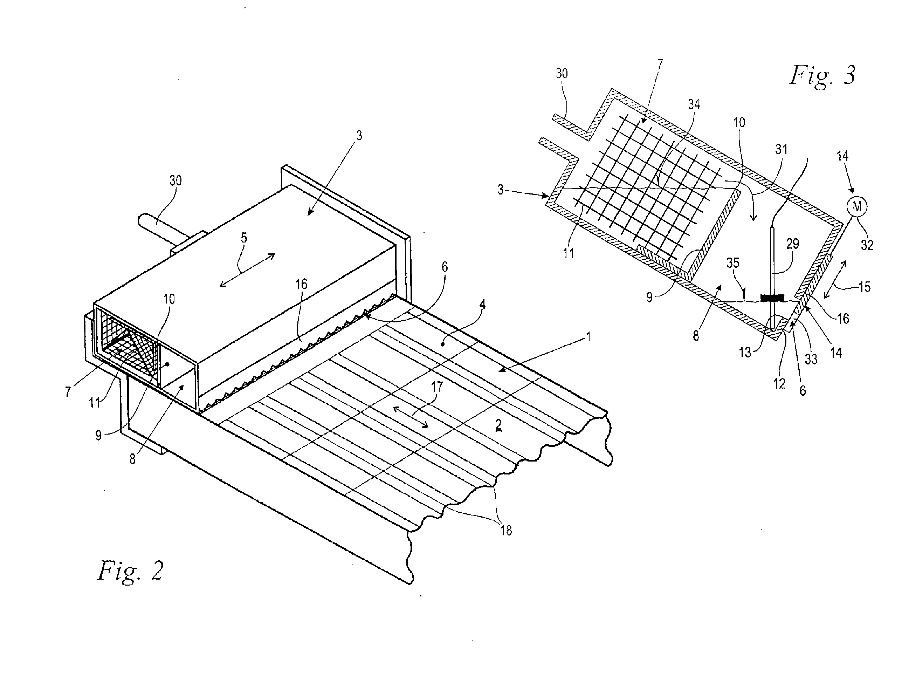

Fig. 2 zeigt in einer perspektivischen, teilweise geschnittenen Ansicht die Befließungsrichtung 3 nach Fig. 1 im Zusammenspiel mit einem ebenfalls nur ausschnittsweise dargestellten Solarmodul 1. Die Befließungseinrichtung 3 umfasst einen in der Querrichtung 5 sich erstreckenden Kasten, durch dessen Wände und eine innenseitig angeordnete Trennwand 9 zwei Beruhigungskammern 7, 8 gebildet sind. In die bezogen auf die Durchströmungsrichtung erste Beruhigungskammer 7 mündet der Wasserzulauf 30, der von der Pumpe 27 (Fig. 1) mit Wasser gespeist wird. Die in Strömungsrichtung zweite, hier letzte Beruhigungskammer 8 ist mit dem Wasseraustritt 6 versehen. Es können noch zusätzliche Beruhigungskammern vorgesehen sein. In der ersten Beruhigungskammer 7 ist ein Beruhigungsgitter 11 in Form eines mehrfach abgewinkelten Drahtgitters angeordnet. Anstelle eines Drahtgitters können auch Stäbe, streifenförmige oder plattenförmige Elemente als Beruhigungsmaßnahmen für die sich in der ersten Beruhigungskammer 7 ausbildende Wasserströmung vorgesehen sein. Des Weiteren kann es zweckmäßig sein, ein Beruhigungsgitter 11 oder andere vergleichbare Mittel in der zweiten Beruhigungskammer 8 anzuordnen. Im Bereich des Wasseraustritts 6 ist noch eine Zahnleiste 16 angeordnet. Weitere Einzelheiten zum konstruktiven Aufbau der Befließungseinrichtung 3 sind im Zusammenhang mit den Fig. 3 bis 5 weiter unten näher beschrieben.

Der hier gezeigte Abschnitt der Befließungseinrichtung 3 erstreckt sich in der horizontalen Querrichtung 5 derart über eine Breite, dass die Breite des Wasseraustrittes 6 mindestens der Breite eines einzelnen Solarmoduls 1 entspricht. Das Gleiche gilt auch für die beiden Beruhigungskammern 7, 8, die ebenfalls mindestens die gleiche Breite wie das Solarmodul 1 und wie der Wasseraustritt 6 aufweisen. Die in Fig. 1 dargestellte Befließungseinrichtung 3 umfasst genauso viele der hier dargestellten Abschnitte, wie Solarmodule 1 in der Querrichtung 5 nebeneinander liegen. Es kann aber auch zweckmäßig sein, die Befließungseinrichtung 3 mit einem der hier gezeigten, über die Breite von mehreren oder sämtlichen Solarmodulen 1 durchgehenden Abschnitte auszubilden.

Es tritt ein in seiner Dicke und Strömungsverteilung vergleichmäßigter Wasserfilm 4 aus dem Wasseraustritt 6 auf und legt sich über die gesamte Breite und damit über die gesamte Fläche der Bestrahlungsseite 2 des Solarmoduls 1. Das Solarmodul 1 ist in einer durch einen Doppelpfeil angegebenen Neigungsrichtung 17 zur Vertikalrichtung geneigt, so dass der Wasserfilm 4 in der Neigungsrichtung 17 auf der Außenseite des Solarmoduls 1 abfließt. Die Oberfläche des Solarmoduls 1 weist auf der Bestrahlungsseite 2 optionale Längsführungen 18 für den Wasserfilm 4 auf, die in der Neigungsrichtung 17 verlaufen. Die Längsführungen 18 können Längsrillen, Längsstege oder dergleichen sein. Richtungskomponenten der Strömung des Wasserfilmes 4 quer zur Falllinie bzw. zur Neigungsrichtung 17 werden dadurch vermieden.

Fig. 3 zeigt eine schematische Querschnittsdarstellung der Befließungseinrichtung 3 nach den Fig. 1 und 2, demnach die beiden Beruhigungskammern 7, 8 mittels der Trennwand 9 voneinander getrennt sind. Die Querschnittslängsachse der Befließungseinrichtung 3 ist um das gleiche Maß wie die Trägerkonstruktion 21 (Fig. 1) mit den Solarmodulen 1 geneigt. Mit einer Änderung des Neigungswinkels α (Fig. 1) ändert sich auch der Neigungswinkel der Befließungseinrichtung 3.

Das durch den Wasserzulauf 30 in die erste Beruhigungskammer 7 einströmende Wasser wird mittels des Beruhigungsgitters 11 in der Querrichtung 5 (Fig. 2) gleichmäßig verteilt, strömungsberuhigt, und bildet infolge der Aufstauwirkung der Trennwand 9 einen ersten Wasserspiegel 34. Die Trennwand 9 ist mit einer in der horizontalen Querrichtung 5 (Fig. 2) sich erstreckenden Umströmungskante 10 versehen, die hier als in Gewichtskraftrichtung obere Überlaufkante ausgeführt ist. Nachdem der erste Wasserspiegel 34 bis zur Umströmungskante 10 angestiegen ist, strömt das Wasser aus der ersten Beruhigungskammer 7 entsprechend einem Pfeil 31 über die Umströmungskante 10 in die zweite Beruhigungskammer 8, wo sich ein zweiter Wasserspiegel 35 im Bereich des Wasseraustrittes 6 ausbildet. Die Höhe des Füllstandes bzw. des zweiten Wasserspiegels 35 in der zweiten Beruhigungskammer 8 wird mittels eines schematisch angedeuteten Füllstandssensors 29 gemessen. Der Füllstandssensor 29 bildet zusammen mit der Pumpe 27 und dem geschlossenen Wasserkreislauf 23 (Fig. 1) einen Regelkreis, mittels dessen die Höhe des zweiten Wasserspiegels 35 konstant gehalten wird.

Die zweite Beruhigungskammer 8 ist mit einer in der horizontalen Querrichtung 5 (Fig. 2) sich erstreckenden Schwelle 12 versehen, die bezogen auf die Gewichtskraftrichtung nach oben mittels einer ebenfalls in der horizontalen Querrichtung 5 sich erstreckenden Schwellenkante 13 begrenzt ist. Die Schwelle 12 bildet zusammen mit ihrer Schwellenkante 13 den Wasseraustritt 6.

Der Darstellung nach Fig. 3 ist zu entnehmen, dass die hier im Querschnitt dargestellte Zahnleiste 16 mittels eines Antriebes 32 in einer durch einen Doppelpfeil angegebenen Hochrichtung 15 verstellbar ist. Zähne 33 der Zahnleiste 16 decken dabei die Schwelle 12 mit ihrer Schwellenkante 13 zumindest teilweise ab. Mittels der Baueinheit aus dem Antrieb 32 und der Zahnleiste 16 ist eine Steuerungseinrichtung 14 zur Einstellung des freien Strömungsquerschnittes des Wasseraustrittes 6 gebildet. Abhängig von der eingestellten Höhenposition der Zahnleiste 16 bilden sich mehr oder weniger große Zwischenräume zwischen den Zähnen 33 und der Schwellenkante 13, wodurch der durch den Wasseraustritt 6 austretende Volumenstrom des Wassers eingestellt werden kann. Die vorstehend beschriebene Steuerungseinrichtung 14 kann vom Benutzer nach Bedarf eingestellt werden. Ergänzend kann es möglich sein, die Steuerungseinrichtung 14 in einen Regelkreis zur Anpassung und Konstanthaltung des austretenden Wasservolumenstromes einzubinden.

In Verbindung mit einer geeigneten übergeordneten, beispielsweise computergesteuerten Steuerung bzw. Regelung lässt sich der Wasserfilm 4 an die verschiedenen Witterungsbedingungen und Neigungswinkel α der Trägerkonstruktion 21 (Fig. 1) anpassen. Zur optimalen Befließung bzw. Warmwassergewinnung können die vorstehend beschriebenen Parameter an die augenblicklichen Umstände und auch an das Temperaturziel für das Speicherwasser angepasst werden. Wenn zum Beispiel die Witterung kühl und der Himmel bewölkt ist, wenn also die Temperatur der Solarmodule 1 nicht mehr als 30°C beträgt, ist eine Befließung zur Kühlung nicht nötig. Außerdem lässt sich kein Warmwasser gewinnen. Die Pumpe 27 (Fig. 1) kann ausgeschaltet werden. Sofern man jedoch bei kräftigem Sonnenschein Warmwasser mit möglichst hoher Temperatur speichern will, lässt man einen möglichst geringem Wasservolumenstrom zur Ausbildung des Wasserfilmes 4 über die Solarmodule 1 fließen. Auf diese Weise wird die Temperatur des Wassers und damit die erreichbare Temperatur im Wasserspeicher möglichst hoch.

Zwischen den beiden vorstehend beschriebenen Extremen können nahezu beliebige Zwischenwerte eingestellt werden, die einen guten Kompromiss zwischen Kühlwirkung an den Solarmodulen 1 und der erzielten Wassertemperatur darstellen. Als Einflussparameter spielt dabei auch der eingestellte Neigungswinkel α der Trägerkonstruktion 21 (Fig. 1) eine Rolle, in dessen Folge sich eine mehr oder weniger hohe Strömungsgeschwindigkeit des Wasserfilms 4 ausbildet. Bei gegebener Pumpleistung der Pumpe 27 verringert sich die Filmdicke des Wasserfilms 4 mit steigendem Neigungswinkel α und damit steigender Fließgeschwindigkeit. Sofern eine bestimmte Filmdicke des Wasserfilmes 4 angestrebt ist, muss deshalb auch der Neigungswinkel α (Fig. 1) berücksichtigt werden. Deshalb ist es vorteilhaft, wenn gleichzeitig die Sonneneinstrahlung, die Luft- und die Wassertemperatur sowie auch die Dachneigung gemessen werden. Abhängig von diesen Messwerten und den gewünschten Zielen der Kühlwirkung und Warmwassergewinnung können eine automatische Regelung der Pumpenleistung und damit des Füllstandes in der zweiten Beruhigungskammer 8, aber auch die Stellung der Steuerungseinrichtung 14 mit der Zahnleiste 16 durchgeführt werden. Hierzu wird vorteilhaft eine SPS eingesetzt, die gemäß den verschiedenen Anforderungen mit verschiedenen Programmen ausgestattet sein kann, so dass der Anwender jeweils das gewünschte Programm leicht aktivieren kann.

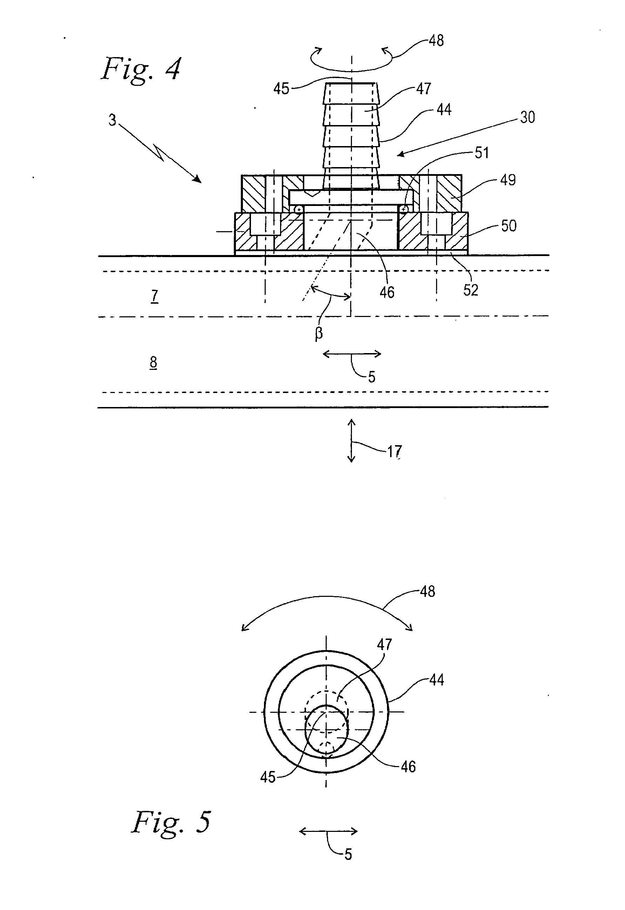

Fig. 4 zeigt in einer geschnittenen Draufsicht die Befließungseinrichtung 3 nach den Fig. 1 bis 3 im Bereich des Wasserzulaufes 30. Die hier gezeigte Schnittebene liegt in der durch die horizontale Querrichtung 5 und die Neigungsrichtung 17 aufgespannten Ebene. Die Befließungseinrichtung 3 ist bezogen auf die Querrichtung 5 insgesamt spiegelsymmetrisch ausgebildet, wobei der Wasserzulauf 30 mittig und quer zur Querrichtung 5 in die erste Beruhigungskammer 7 mündet. Ein Wasserkanal 47 des Wasserzulaufes 30 liegt mit seiner Längsachse senkrecht zur Querrichtung 5. Es kann aber auch eine schrägwinklige bzw. außermittige Anordnung zweckmäßig sein.

Im Einzelnen umfasst der Wasserzulauf 30 einen Einlaufstutzen 44, der mittels einer Klemmplatte 49 an einem Einlaufflansch 50 gehalten ist. Der Einlaufflansch 50 ist unter Zwischenlage einer Dichtung 52 mit einer Stirnwand der ersten Beruhigungskammer 7 verschraubt. Der Einlaufstutzen 44 weist einen umlaufenden Flansch auf, der unter Zwischenlage eines Dichtringes 51 mittels der Klemmplatte 49 gegen den Einlaufflansch 50 dichtend gedrückt ist. Hierdurch ist der Einlaufstutzen 44 gegenüber der ersten Beruhigungskammer 7 wasserdicht gehalten. Nach Lösen von nicht dargestellten Klemmschrauben der Klemmplatten 49 kann der Einlaufstutzen 44 entsprechend einem Pfeil 48 um eine Drehachse 45 gedreht werden, die seiner Längsachse entspricht. Die eingestellte Drehwinkelstellung wird durch Festziehen der vorgenannten Klemmschrauben fixiert.

Der durch den Einlaufstutzen 44 hindurchführende Wasserkanal 47 weist an seinem der ersten Beruhigungskammer 7 zugewandten Ende einen Wasserkanalabschnitt 46 auf, der in einem Winkel β zur Drehachse 45 liegt. Der Winkel β ist größer als 0° und liegt bevorzugt in einem Bereich von einschließlich 15° bis einschließlich 45°. Im gezeigten Ausführungsbeispiel beträgt der Winkel β etwa 30°.

Durch die Ausrichtung des Wasserkanalabschnittes 46 in dem Winkel β gegenüber der Drehachse 45 sind im Bereich des Wasserzulaufes 30 einstellbare Umlenkmittel zur Umlenkung des eintretenden Wasserstromes in die horizontale Querrichtung 5 gebildet. Einzelheiten hierzu ergeben sich aus der Zusammenschau der Fig. 4 und 5.

Fig. 5 zeigt in einer Querschnittsdarstellung den Einlaufstutzen 44 von der Seite seines austretenden Wasserkanalabschnittes 46. Infolge seines Winkels β (Fig. 4) liegt der Austrittsquerschnitt des Wasserkanalabschnittes 46 mit radialem Versatz zum mittigen Wasserkanal 47 bzw. zur Drehachse 45. Nach Fig. 5 ist eine Drehwinkelstellung des Einlaufstutzens 44 eingestellt, die einer Neutralposition entspricht. In dieser Neutralposition ist der Wasserkanalabschnitt 46 mittig nach unten geneigt, kann aber auch mittig nach oben geneigt sein. In beiden Fällen liegt er mittig in der Querrichtung 5, so dass trotz der Winkelstellung des Wasserkanalabschnittes 46 keine Umlenkung des in die erste Beruhigungskammer 7 (Fig. 4) eintretenden Wasserstromes in die Querrichtung 5 erfolgt.

Sofern jedoch die Solarmodule 1 und/oder die Befließungseinrichtung 3 (Fig. 1, 2) in der Querrichtung 5 einen Neigungsfehler aufweisen, kann der Einlaufstutzen 44 zum Ausgleich dieses Neigungsfehlers entsprechend dem Doppelpfeil 48 ausgehend von der Neutralposition nach Fig. 5 gedreht werden. In der Darstellung nach Fig. 4 ist ein Drehwinkel gegenüber der Neutralposition nach Fig. 5 von beispielhaft 90° gewählt, so dass eine maximale seitliche Auslenkung des eintretenden Wasserstromes nach links eintritt. Dies führt dazu, dass ein auf der linken Seite zu dünn eingestellter Wasserfilm aufgedickt wird. In gleicher Weise kann der Einlaufstutzen 44 aber auch in die entgegengesetzte Richtung, also nach rechts gedreht werden, wobei der Wasserfilm 4 (Fig. 1, 2) dann auf der rechten Seite dicker wird, während er auf der linken Seite in seiner Dicke abnimmt. Zwischen diesen Extremen entsprechend der Darstellung nach Fig. 4 und der Neutralstellung nach Fig. 5 können beliebige Zwischenwerte der Drehwinkelposition des Einlaufstutzens 44 eingestellt werden, womit eine beliebige Dickenverteilung des Wasserfilmes 4 in der Querrichtung 5 einstellbar ist. Seitliche Neigungsfehler der Anordnung oder auch andere die Dickenverteilung des Wasserfilms 4 (Fig. 1) beeinflussende Fehler lassen sich demnach in einfacher Weise durch Drehwinkeleinstellung des Einlaufstutzens 44 ausgleichen. Der Einlaufstutzen 44 wird ausgehend von der Neutralposition nach Fig. 5 so weit entsprechend dem Doppelpfeil 48 gedreht, bis sich über die zugeordneten Solarmodule 1 (Fig.1, 2) ein in der Querrichtung 5 gleichmäßig dicker Wasserfilm 4 einstellt, ohne dass ein geometrischer Ausgleich des Neigungsfehlers erforderlich ist. Die gefundene Drehwinkelstellung lässt sich in einfacher Weise mittels der Platte 49 fixieren. Später auftretende Setzungserscheinungen oder dergleichen können ohne weiteres nach Lösen der Klemmplatte 49 und durch Nachdrehen des Einlaufstutzens 44 auskorrigiert werden.

Fig. 6 zeigt in einer Draufsicht eine vergrößerte Detaildarstellung der Solaranlage nach Fig. 1 im Bereich zweier in der Neigungsrichtung 17 aneinander angrenzenden Solarmodule 1. Die Solarmodule 1 weisen eine handelsübliche Grundfläche auf, demnach zur Bedeckung der gesamten Wohnfläche mehrere solcher Solarmodule 1 in der Querrichtung 5 nebeneinander und in der Neigungsrichtung 17 untereinander anzuordnen sind. Dabei bildet sich jeweils zwischen den einzelnen Solarmodulen 1 eine Fuge 38 aus, die sich hier in der Querrichtung 5 erstreckt. Zur Abdeckung dieser Fuge 38 und zur Führung des Wasserfilmes 4 (Fig. 5) über diese Fuge 38 ist eine Übergangsleiste 36 vorgesehen, die sich in der Querrichtung 5 erstreckt, die die Fuge 38 vollständig abdeckt bzw. überspannt, und die in der Querrichtung 5 verteilte und in der Neigungsrichtung 17 ausgerichtete Leiteinrichtungen 37 aufweist. Die Leiteinrichtungen 37 können in der Neigungsrichtung 17 verlaufende Leitbleche oder dergleichen sein. Im gezeigten Ausführungsbeispiel sind sie durch eine in der Querrichtung 5 wechselseitige Anordnung von Rippen 39 und zwischenliegenden Kanälen 40 gebildet.

Fig. 7 zeigt eine Querschnittsdarstellung der Anordnung nach Fig. 4, demnach die Übergangsleiste 36 einen etwa halbkreisförmigen Querschnitt aufweist. Aus der Zusammenschau mit Fig. 4 ergibt sich, dass der vorgenannte Querschnitt der Übergangsleiste 36 in Verbindung mit den Rippen 39 und Kanälen 40 dadurch gebildet ist, dass ein im Querschnitt der Länge nach halbierter Wellstab zum Einsatz kommt. Hierzu wird ein im Querschnitt kreisrunder Stab insbesondere aus Kunststoff auf einer Drehbank mit einer Wellenform versehen, wobei die Wellen in Umfangsrichtung umlaufen. Dieser Wellstab wird dann der Länge nach aufgeschnitten. Es muss kein exakt halbierter Querschnitt vorgesehen sein. Auch andere Umfangsabschnitte eines solchen Wellstabes, die beispielsweise nur ein Drittel des Querschnittes bzw. des Umfanges eines solchen Wellstabes ausmachen, können zweckmäßig sein. Die Rippen 39 und Kanäle 40 weisen demnach in der Querrichtung 5 eine Wellenform auf und verlaufen in der Neigungsrichtung kreisabschnittförmig über den Umfang der Übergangsleiste 36. Alternativ kann die Übergangsleiste 36 auch durch ein im Querschnitt der Länge nach geteiltes, handelsübliches Wellrohr gebildet werden.

Der Darstellung nach Fig. 7 kann entnommen werden, dass in der Fuge 38 zwischen den beiden benachbarten Solarmodulen 1 eine Dichtung 41 angeordnet ist, die auf der Bestrahlungsseite 2 geringfügig über die Oberfläche der Solarmodule 1 hervorsteht. Hierdurch dient sie neben der gegenseitigen Abder beiden Solarmodule 1 auch als Befestigungsmittel für die Übergangsleiste 36, indem sie in eine unterseitige Nut der Übergangsleiste 36 eingreift. Des Weiteren ist zu erkennen, dass das Profil der Übergangsleiste 36 sich im montierten Zustand über die Oberfläche der Solarmodule 1 auf deren Bestrahlungsseite 2 erhebt und dabei die Fuge 38 zwischen den Solarmodulen 1 vollständig überspannt. Hierdurch wird erreicht, dass der Wasserfilm 4 des bezogen auf die Neigungsrichtung 17 oberen Solarmoduls 1 unter Bildung eines dritten Wasserspiegels 42 an der Übergangsleiste 36 aufgestaut wird und dann zwischen den Rippen 39 durch die Kanäle 40 (Fig. 6) entsprechend einem Pfeil 43 unter Überwindung der Fuge 38 zu dem in der Neigungsrichtung 17 nachfolgenden, unteren Solarmodul 1 hindurchtritt. In Folge der Strukturierung der Übergangsleiste 36 bildet sich dann auf der Bestrahlungsseite 2 des unteren Solarmoduls 1, ebenso wie beim oberen Solarmodul 1, ein gleichmäßiger Wasserfilm 4 aus. Die Kanäle 40 sind in Folge ihrer nach außen bzw. in radialer Richtung offenen Bauweise selbstreinigend, so dass eine Verschmutzung bzw. Verstopfung durch Laub etc. vermieden ist. Ergänzend kann aber zur Verhinderung von Verstopfung ein Schutzgitter stromauf der Übergangsleiste 36 oder in vollständiger, käfigartiger Abdeckung der Übergangsleiste 36 angeordnet werden.

Sämtliche in der Querrichtung 5 verlaufende Fugen 38 sind entsprechend der Darstellung nach Fig. 1 auf diese Weise mit einer Übergangsleiste 36 versehen, so dass sich auf der Bestrahlungsseite 2 sämtlicher Solarmodule 1, also auf der Gesamtfläche der Solaranlage, ein gleichmäßiger Wasserfilm 4 ausbildet.

## Patentansprüche

1. Befließungseinrichtung (3) für eine Solaranlage mit einer Anordnung von schräg zur Horizontalen ausgerichteten photovoltaischen Solarmodulen (1), die mit einer Bestrahlungsseite (2) der Sonne zugewandt sind, wobei die Befließungseinrichtung (3) zur Erzeugung eines sich auf der Bestrahlungsseite (2) der Solarmodule (1) ausbildenden, zur Umgebung hin offenen fließenden Wasserfilmes (4) vorgesehen ist, und wobei die Befließungseinrichtung (3) einen in einer horizontalen Querrichtung (5) sich erstreckenden Wasseraustritt (6) aufweist,
**dadurch gekennzeichnet, dass** die Befließungseinrichtung (3) mindestens zwei Beruhigungskammern (7, 8) aufweist, wobei die in Durchströmungsrichtung letzte Beruhigungskammer (8) mit dem Wasseraustritt (6) versehen ist, und wobei zwischen den Beruhigungskammern (7, 8) eine Trennwand (9) mit einer in der horizontalen Querrichtung (5) sich erstreckenden Umströmungskante (10) verläuft.

2. Befließungseinrichtung nach Anspruch 1,
**dadurch gekennzeichnet, dass** die Umströmungskante (10) eine in Gewichtskraftrichtung obere Überlaufkante ist.

3. Befließungseinrichtung nach Anspruch 1 oder 2,
**dadurch gekennzeichnet, dass** sich die beiden Beruhigungskammern (7, 8) über die gesamte Breite des Wasseraustrittes (6) erstrecken.

4. Befließungseinrichtung nach einem der Ansprüche 1 bis 3,
**dadurch gekennzeichnet, dass** zumindest in der eingangsseitigen Beruhigungskammer (7) ein Beruhigungsgitter (11) angeordnet ist.

5. Befließungseinrichtung nach einem der Ansprüche 1 bis 4,
**dadurch gekennzeichnet, dass** der Wasseraustritt (6) durch eine Schwelle (12) mit einer in der horizontalen Querrichtung (5) sich erstreckenden Schwellenkante (13) gebildet ist.

6. Befließungseinrichtung nach einem der Ansprüche 1 bis 5,
**dadurch gekennzeichnet, dass** eine Steuerungseinrichtung (14) zur Einstellung des freien Strömungsquerschnittes des Wasseraustrittes (6) vorgesehen ist.

7. Befließungseinrichtung nach den Ansprüchen 5 und 6,
**dadurch gekennzeichnet, dass** die Steuerungseinrichtung (14) durch eine die Schwellenkante (13) überdeckende, in einer Hochrichtung (15) verstellbare Zahnleiste (16) gebildet ist.

8. Befließungseinrichtung nach einem der Ansprüche 1 bis 7,
**dadurch gekennzeichnet, dass** ein insbesondere mittig und quer zur horizontalen Querrichtung (5) in die erste Beruhigungskammer (7) mündender Wasserzulauf (30) vorgesehen ist, wobei im Bereich des Wasserzulaufes (30) einstellbare Umlenkmittel zur Umlenkung des eintretenden Wasserstromes in die horizontale Querrichtung (5) angeordnet sind, und wobei insbesondere der Wasserzulauf (30) einen drehbaren Einlaufstutzen (44) umfasst, dessen Drehachse (45) quer zur Querrichtung (5) liegt, wobei der Einlaufstutzen (44) einen der ersten Beruhigungskammer (7) zugewandten Wasserkanalabschnitt (46) aufweist, und wobei der Wasserkanalabschnitt (46) zur Bildung der Umlenkmittel in einem Winkel (β) zur Drehachse (45) liegt.

9. Solaranlage mit einer Befließungseinrichtung (3) mit den Merkmalen nach einem der Ansprüche 1 bis 8.

10. Solaranlage nach Anspruch 9,
**dadurch gekennzeichnet, dass** die Breite des Wasseraustrittes (6) der Breite eines einzelnen Solarmoduls (1) entspricht.

11. Solaranlage nach Anspruch 9 oder 10,
**dadurch gekennzeichnet, dass** das Wasser zur Bildung des Wasserfilmes (4) mit Tensiden versetzt ist.

12. Solaranlage nach einem der Ansprüche 9 bis 11,
**dadurch gekennzeichnet, dass** die Oberfläche der Solarmodule (1) auf der Bestrahlungsseite (2) in einer Neigungsrichtung (17) verlaufende Längsführungen (18) für den Wasserfilm (4) aufweist.

13. Solaranlage nach einem der Ansprüche 9 bis 12,
**dadurch gekennzeichnet, dass** eine Regelungseinrichtung für eine Füllstandsregelung des Wassers in der Beruhigungskammer (7, 8), insbesondere in der letzten Beruhigungskammer (8) vorgesehen ist.

14. Solaranlage nach einem der Ansprüche 9 bis 13,
**dadurch gekennzeichnet, dass** eine Übergangsleiste (36) zur Montage im Übergangsbereich von zwei in der Neigungsrichtung (17) aneinander angrenzenden Solarmodulen (1) vorgesehen ist und sich dabei in der Querrichtung (5) erstreckt, wobei die Übergangsleiste (36) in der Querrichtung (5) verteilte und in der Neigungsrichtung (17) ausgerichtete Leiteinrichtungen (37) aufweist.

15. Solaranlage nach Anspruch 14,
**dadurch gekennzeichnet, dass** die Übergangsleiste (36) durch ein Profil und insbesondere durch einen der Länge nach geteilten Wellstab gebildet ist, wobei das Profil sich im montierten Zustand über die Oberfläche der Solarmodule (1) auf deren Bestrahlungssseite (2) erhebt und dabei eine Fuge (38) zwischen den Solarmodulen (1) überspannt, und wobei die Leiteinrichtungen (37) durch eine wechselseitige Anordnung von Rippen (39) und zwischenliegenden Kanälen (40) gebildet sind.
